# EUROPÄISCHE PATENTSCHRIFT

(11) **EP 2 638 344 B1**
(45) Veröffentlichungstag und Bekanntmachung des Hinweises auf die Patenterteilung: **06.03.2019**
(21) Anmeldenummer: 11773006.9
(22) Anmeldetag: 24.10.2011
(51) Int. Cl.: F25D 23/06, F25D 27/00

(54) **HINTERLEGTEIL FÜR DIE BEFESTIGUNG EINER ELEKTRISCHEN KOMPONENTE AN EINER GEHÄUSEWAND**
BACKING PIECE FOR ATTACHING AN ELECTRICAL COMPONENT TO A HOUSING WALL
PIÈCE DE SUPPORT POUR LA FIXATION D'UN ÉLÉMENT ÉLECTRIQUE SUR UNE PAROI DE BOÎTIER

(30) Priorität: 08.11.2010 DE 102010043546
(43) Veröffentlichungstag der Anmeldung: 18.09.2013
(73) Patentinhaber: BSH Hausgeräte GmbH, 81739 München (DE)
(72) Erfinder: HEINRICH, Alexander, 78054 Villingen-Schwenningen (DE); WIEDENMANN, Matthias, 89189 Neenstetten (DE)
(86) Internationale Anmeldenummer: PCT/EP2011/068537
(87) Internationale Veröffentlichungsnummer: WO 2012/062561

(56) Entgegenhaltungen:
- EP-A1- 0 892 230
- EP-A2- 0 615 071
- DE-A1-102006 012 922
- DE-A1-102009 000 667
- DE-U1- 29 606 772

## Beschreibung

Die vorliegende Erfindung betrifft ein Hinterlegteil für die Befestigung einer elektrischen Komponente an der Gehäusewand eines Haushaltselektrogeräts.

Ein Hinterlegteil der betreffenden Art dient insbesondere der Befestigung einer elektrischen Komponente (wie z. B. ein Leuchtmittel, ein Temperaturfühler oder dergleichen) an der Innenwand bzw. Innenbehälterwand eines Kältegeräts. Ein solches Hinterlegteil ist z. B. aus der DE 10 2005 021 562 A1 bekannt (vgl. Rückwand 14 in der Fig. 2). Dieses Hinterlegteil wird hinter einer passenden Öffnung in der Gehäusewand angeordnet und stützt sich mit einem integrierten, die Öffnung umlaufenden Randsteg an der Rückseite der Gehäusewand ab. Die Befestigung des Hinterlegteils und die Abdichtung erfolgt durch Verkleben des Randstegs. Dieses Verkleben ist aufwändig. Zudem wird häufig keine ausreichende und dauerhafte Abdichtung erzielt.

Die Offenlegungsschrift DE 10 2006 012 922 A1 zeigt eine Anordnung mit einer Wand und einem in einer Öffnung der Wand verankerten Bauteil.

Die Offenlegungsschrift EP 0 892 230 A1 zeigt ein Kältegerät, wobei in einer Ausnehmung einer Innenwand des Kältegeräts eine Leuchteinrichtung eingesetzt ist.

Die Offenlegungsschrift DE 10 2009 000 667 A1 zeigt ein Haushaltskühlgerät mit einem Aufnahmeraum, in welchem ein Halteteil zum Halten eines Temperaturfühlers, eines Leuchtmittels und/oder eines Thermostats vorgesehen ist.

Die Gebrauchsmusterschrift DE 29 606 772 U1 zeigt eine Vorrichtung zum elektrischen Anschluss von Kühlgerätebauteilen.

Die Offenlegungsschrift EP 0 615 071 A2 zeigt ein Halteelement aus Kunststoff.

Eine Aufgabe der Erfindung ist es, ein Hinterlegteil der eingangs genannten Art bereitzustellen, das sich einfach befestigen lässt und mit dem eine zuverlässige Abdichtung erzielt werden kann.

Diese Aufgabe wird gelöst von einem Hinterlegteil mit den Merkmalen des Anspruchs 1. Bevorzugte Weiterbildungen und Ausgestaltungen sind in den abhängigen Ansprüchen angegeben. Gemäß den nebengeordneten Ansprüchen erstreckt sich die Lösung der Aufgabe auch auf eine Beleuchtungseinrichtung, auf ein Kältegerät und auf ein Verfahren zur Montage des erfindungsgemäßen Hinterlegteils an einer Gehäusewand. Bevorzugte Weiterbildungen und Ausgestaltungen ergeben sich hierfür analog.

Zur Lösung der Aufgabe wird ein Hinterlegteil vorgeschlagen, welches dazu ausgelegt ist, hinter einer passenden Öffnung in der Gehäusewand angeordnet bzw. befestigt zu werden. Das Hinterlegteil weist einen Korpus und einen (integrierten) die Öffnung umlaufenden Randsteg auf, mit dem es sich an der Rückseite der Gehäusewand abstützt. Es ist vorgesehen, dass dieser umlaufende Randsteg als elastische Dichtlippe ausgebildet ist, die dichtend gegen die Rückseite der Gehäusewand angedrückt wird. Das Hinterlegteil ist hierzu mit einer Vielzahl von Halteelementen ausgebildet, die vom Korpus abstehen und zwischen sich und der Dichtlippe einen Spalt bilden, der dazu ausgelegt ist, einen Abschnitt der Gehäusewand am Rand der Öffnung aufzunehmen. Bevorzugt umgreifen und/oder hintergreifen die Halteelemente von der Rückseite her den Rand der Öffnung in der Gehäusewand. Ferner ist vorgesehen, dass diese Halteelemente derart verteilt angeordnet sind, dass in jeden Abschnitt der Dichtlippe eine ausreichende Anpresskraft eingeleitet wird, so dass diese rundum zuverlässig und dauerhaft gegen die Rückseite der Gehäusewand angedrückt wird, wenn das Hinterlegteil hinter der passenden Öffnung in der Gehäusewand befestigt ist.

Das erfindungsgemäße Hinterlegteil kann ohne Verklebung befestigt werden, wodurch der Montageaufwand verringert und Kosten eingespart werden. Die Halteelemente sind bevorzugt so ausgebildet und angeordnet, dass gegenüber der Öffnung in der Gehäusewand eine Montagetoleranz gegeben ist. Durch den Entfall der Verklebung kann das erfindungsgemäße Hinterlegteil auch einfacher demontiert werden. Ferner wird eine zuverlässige Befestigung und dauerhafte Abdichtung gegenüber der Gehäusewand erzielt. Insbesondere ist die erzielte Abdichtung schaumdicht, um ein Hinterschäumen bzw. Ausschäumen der Gehäusewand im Bereich des Hinterlegteils zu ermöglichen, ohne dass das Schaummaterial (insbesondere ein Isolationsschaum) zur Vorderseite durchdringt. Die Rückseite der Gehäusewand kann insofern auch als Schaumseite bezeichnet werden.

Bevorzugt ist vorgesehen, dass das gesamte Hinterlegteil, d. h. einschließlich der Dichtlippe und den Halteelementen, einstückig aus einem kältefesten Kunststoffmaterial hergestellt ist. Insbesondere ist das Hinterlegteil als Spritzgussteil ausgebildet.

Ferner ist bevorzugt vorgesehen, dass die Halteelemente flächig ausgebildet sind und sich in etwa parallel zur Dichtlippe und/oder parallel zur Gehäusewand erstrecken. Durch die flächige Ausbildung wird insbesondere auch eine flache Ausbildung dieser Halteelemente ermöglicht, so dass diese nicht zu weit über die Vorderseite der Gehäusewand vorstehen, was bspw. bei herkömmlichen Rastelementen der Fall wäre. Zudem kann vorgesehen sein, dass die Halteelemente federelastisch ausgebildet sind, wodurch u. a. die Montage des Hinterlegteils insbesondere bei größeren Wanddicken der Gehäusewand erleichtert wird.

Die Halteelemente sind erfindungsgemäß derart um den Umfang des Hinterlegteils verteilt, dass an jeder Seite eines rechteckigen Hinterlegteils zumindest ein Halteelement angeordnet ist. Auf diese Weise wird gewährleistet, dass über den gesamten Umfang der Dichtlippe ine ausreichende Anpresskraft eingeleitet wird. Zusätzlich ist jeweils ein Halteelement an den Ecken des Hinterlegteils vorgesehen. Bevorzugt kann zudem vorgesehen sein, dass wenigstens ein Halteelement gleichfalls als Fixierelement ausgebildet ist, welches das Hinterlegteil in einer vorgesehenen und insbesondere idealen Position gegenüber der Öffnung in der Gehäusewand fixiert. Durch das Fixierelement wird ein ungewolltes Verschieben des Hinterlegteils verhindert. Insbesondere ist vorgesehen, dass dieses Fixierelement als Rastelement ausgebildet ist, welches aus seiner Verrastung gelöst werden muss, um das Hinterlegteil demontieren zu können. Dies kann z.B. dadurch realisiert sein, dass das das Fixierelement eine Stufe auf seiner der Dichtlippe zugewandten Seite aufweist, welche eine Rastposition für den Rand der Öffnung darstellt. Beim Einsetzen kann das Fixierelement bevorzugt über die Stufe hinaus den Rand der Öffnung in der Gehäusewand umgreifen, zum fixieren wird das Halteelement dann soweit zurückgezogen, dass seine Stufe am Rand der Öffnung anliegt.
Des weiteren ist bevorzugt vorgesehen, dass die Dichtlippe flächig und insbesondere mit einer leichten Neigung (bezüglich der Gehäusewand) ausgebildet ist. Durch diese leichte Neigung der Dichtlippe kann für unterschiedliche Wanddicken der Gehäusewand ein zuverlässiges Anliegen der Dichtlippe und damit eine dauerhafte Abdichtung gegenüber der Gehäusewand gewährleistet werden. Dies ist insbesondere für die teilweise großen fertigungstoleranzbedingten Wanddickenschwankungen bei den Innenbehältern eines Kältegeräts relevant, die nicht zu Undichtigkeiten führen dürfen. Die abragende Breite der Dichtlippe beträgt idealerweise wenigstens 15 mm, bevorzugt wenigstens 20 mm und insbesondere wenigstens 25 mm.
Gemäß einer bevorzugten Weiterbildung ist vorgesehen, dass das Hinterlegteil einen Korpus aufweist, von dem die Dichtlippe umlaufend abragt. Insbesondere ist vorgesehen, dass die kleinste Seitenlänge des Korpus wenigstens 30 mm, bevorzugt wenigstens 40 mm und insbesondere wenigstens 50 mm beträgt. Trotz eines derart verhältnismäßig großen Korpus gelingt eine zuverlässige Befestigung und Abdichtung des Hinterlegteils.

Die Abdichtung in längeren Seitenabschnitten kann durch das Vorsehen wenigstens eines Halteelements in einem solchen Seitenabschnitt, welches in diesem Bereich eine Anpresskraft in die Dichtlippe einleitet, bewerkstelligt werden.

Zur Erleichterung der Montage und/oder Demontage kann am Korpus wenigstens eine Griffeinrichtung angeordnet sein. Bevorzugt sind mehrere Griffeinrichtungen vorgesehen, die ein einfaches Greifen des Hinterlegteils mit der Hand ermöglichen. Ferner ist bevorzugt vorgesehen, dass der Korpus mit einer Verrippung ausgebildet ist, um dessen mechanische Stabilität zu erhöhen. Gemäß einer besonders bevorzugten Ausgestaltung ist der Korpus mit einem integrierten Reflektorabschnitt zur Reflektion und/oder Verteilung des Lichts einer Lichtquelle ausgebildet. Ferner kann der Korpus mit einem Anschlussstück für die elektrische Kontaktierung der Lichtquelle oder einer sonstigen elektronischen Komponente ausgebildet sein.

Die Lösung der oben genannten Aufgabe erstreckt sich ferner auf eine Beleuchtungseinrichtung, die ein erfindungsgemäßes Hinterlegteil und ein damit verbindbares Oberteil aufweist. Insbesondere handelt es sich hierbei um eine Innenbeleuchtungseinrichtung für ein Kältegerät, die an einer Innenwand (Innenbehälterwand) des gekühlten Innenraums befestigt wird. Bevorzugt ist vorgesehen, dass das Oberteil lösbar mit dem Hinterlegteil verbindbar ist. Insbesondere ist vorgesehen, dass es sich bei dem Oberteil lediglich um eine lichtdurchlässige Abdeckung handelt, während die Lichtquelle und die zugehörige Kontaktierung, ggf. auch die Steuerung, im Hinterlegteil untergebracht sind.

Die Lösung der oben genannten Aufgabe erstreckt sich auch auf ein Kältegerät oder Haushalteelektrogerät, das wenigstens ein erfindungsgemäßes Hinterlegteil und/oder wenigstens eine Beleuchtungseinrichtung gemäß den vorausgehenden Ausführungen aufweist. Insbesondere handelt es sich um ein Haushaltskältegerät, wie bspw. einen Kühlschrank, einen Weinlagerschrank, einen Gefrierschrank oder dergleichen.

Die Lösung der oben genannten Aufgabe erstreckt sich zudem auch auf ein Verfahren zur Montage eines erfindungsgemäßen Hinterlegteils an der Gehäusewand eines Haushaltselektrogeräts, wobei das Hinterlegteil von der Rückseite her in eine passende Öffnung in der Gehäusewand eingesetzt und nachfolgend in einer entgegengesetzten Bewegungsrichtung in der Ebene der Gehäusewand verschoben wird, bis alle Halteelemente des Hinterlegteils den Rand der Öffnung in der Gehäusewand umgreifen und/oder hintergreifen. Dieses Montageverfahren unterscheidet sich deutlich zu den konventionellen Einsteckverfahren. Ein wesentlicher Vorteil ist darin zu sehen, dass die Montage und/oder Demontage auch bei beengten Platzverhältnissen einfach und rationell vorgenommen werden kann. Bevorzugt wird das Hinterlegteil von der Rückseite her in eine passende Öffnung in der Gehäusewand schräg eingesetzt und so weit wie möglich vorgeschoben, bis alle Halteelemente durch die Öffnung reiche. Daraufhin wird das Hinterlegteil in einer entgegengesetzten Bewegungsrichtung in der Ebene der Gehäusewand verschoben, bis alle Halteelemente von der Vorderseite der Gehäusewand zumindest teilweise auf dieser aufliegen, bzw. einen Abschnitt der Gehäusewand zwischen sich und die Dichtlippe klemmen. Besonders bevorzugt ist die Vorschubrichtung des Hinterlegteils in dieser Richtung bis zu der Rastposition eines Fixierelements begrenzt. z.B. bis der Rand der Öffnung an einer Stufe des Fixierelements einrastet.

Weitere Vorteile der Erfindung ergeben sich aus der nachfolgenden, beispielhaften Beschreibung eines Ausführungsbeispiels unter Bezugnahme auf die beigefügten Figuren. Es zeigen:
- **Fig.** 1: die Draufsicht auf ein erfindungsgemäßes Hinterlegteil;
- **Fig. 2**: einen Schnitt durch das Hinterlegteil der Fig. 1 gemäß dem in Fig. 1 angegebenen Schnittverlauf;
- **Fig. 3**: die vergrößerte Darstellung eines Halteelements in einer schematischen Schnittansicht;
- **Fig. 4**: die Kontur der Öffnung in der Gehäusewand mit Blick auf die Rückseite;
- **Fig. 5**: das an einer Gehäusewand befestigte Hinterlegteil der Fig. 1 in einer perspektivischen Ansicht mit Blick auf die Vorderseite; und
- **Fig. 6**: das an einer Gehäusewand befestigte Hinterlegteil der Fig. 1 in einer perspektivischen Ansicht mit Blick auf die Rückseite.

Die im Folgenden verwendeten Richtungsangaben beziehen sich auf die in den Figuren gezeigten Darstellungen.

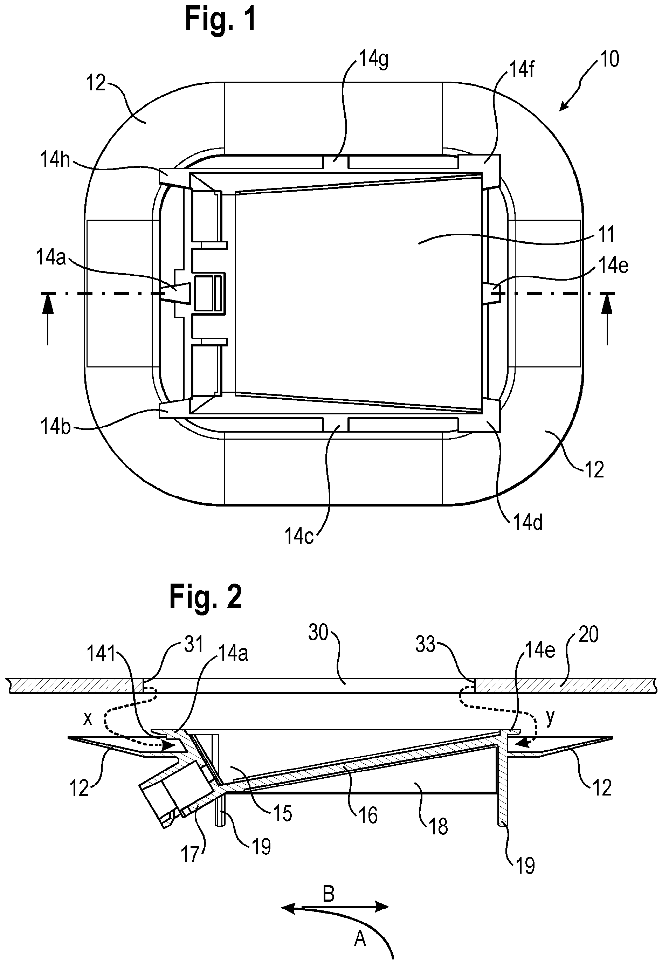

Fig. 1 zeigt ein insgesamt mit 10 bezeichnetes Hinterlegteil. Das Hinterlegteil 10 weist einen in der Draufsicht rechteckigen Korpus 11 auf, an dem eine vollständig umlaufende elastische Dichtlippe 12 angeordnet ist. In der gezeigten Draufsicht ist sehr gut die großflächige Ausbildung der Dichtlippe 12 zu erkennen. Der Korpus 11 dient als Träger für wenigstens eine elektrische Komponente.

Das Hinterlegteil 10 ist dafür vorgesehen, hinter einer passenden Öffnung in einer Gehäusewand angeordnet zu werden, wobei der Korpus 11 im wesentlichen hinter dieser Öffnung positioniert wird und sich die Dichtlippe 12 rings um die Öffnung herum auf der Rückseite der Gehäusewand anlegt. Zur Befestigung ist der Korpus 11 des Hinterlegteils 10 rundum mit insgesamt acht laschenartigen Halteelementen 14a bis 14h ausgebildet, welche von der Rückseite her den Rand der Öffnung in der Gehäusewand umgreifen und/oder hintergreifen, wie nachfolgend noch näher erläutert.

Durch die Verteilung bzw. Anordnung der Halteelemente 14a bis 14h wird in jeden Abschnitt der Dichtlippe 12 eine ausreichende Anpresskraft eingeleitet, so dass diese rundum zuverlässig und dauerhaft gegen die Rückseite der Gehäusewand angedrückt wird. Die Halteelemente 14b, 14d, 14f und 14h befinden sich in den Eckbereichen des Korpus 11. Die Halteelemente 14a, 14c, 14e und 14g befinden sich mittig in den Seitenbereichen des Korpus 11. Die linksseitigen Halteelemente 14a, 14b und 14h sind länger als die rechtsseitigen Halteelemente 14d, 14e und 14f ausgebildet.

Durch die großflächige Ausbildung der Dichtlippe 12 wird eine optimale Abstützung und vor allem auch schaumdichte Abdichtung an der Rückseite der Gehäusewand erzielt, wodurch ein Hinterschäumen des Hinterlegteils 10, bei dem zuweilen hohe Drücke auftreten, ermöglicht wird, ohne dass das eingebrachte Schaummaterial zur Vorderseite durchdringt.

Fig. 2 zeigt das Hinterlegteil 10 in einer Schnittansicht. In dieser Darstellung ist sehr gut die dünnwandig und flache Ausbildung der Dichtlippe 12 zu erkennen (z. B. beträgt die Gesamthöhe der Dichtlippe 12 maximal 1,5 mm). Die Dichtlippe 12 ist zu ihrem Außenrand hin mit einer leichten Neigung (ca. 5° bis 15°) ausgebildet. Ferner nimmt die Wandstärke der Dichtlippe 12 zum Außenrand hin ab. Beides ist im Hinblick auf die Dichtwirkung vorteilig. In der Darstellung der Fig. 2 ist ferner sehr gut zu erkennen, dass die Halteelemente 14a und 14e flächig und verhältnismäßig flach ausgebildet sind und sich in etwa parallel zur Dichtlippe 12 erstrecken, was für alle Halteelemente gleichermaßen gilt.

Bei dem in den Figuren gezeigten Hinterlegteil 10 handelt es sich um ein Leuchtenhinterlegteil, das für die Aufnahme einer Lichtquelle in dem mit 15 gekennzeichneten Bereich ausgebildet ist. Ferner weist das Hinterlegteil 10 einen Reflektorabschnitt 16 sowie ein Anschlussstück 17 für die elektrische Kontaktierung auf. Die Rückseite des Reflektorabschnitts 16 ist mit Versteifungsrippen 18 ausgebildet. Mit 19 sind Griffeinrichtungen bezeichnet, die zum Zwecke der Montage oder Demontage ein einfaches Greifen des Hinterlegteils 10 mit der Hand ermöglichen.

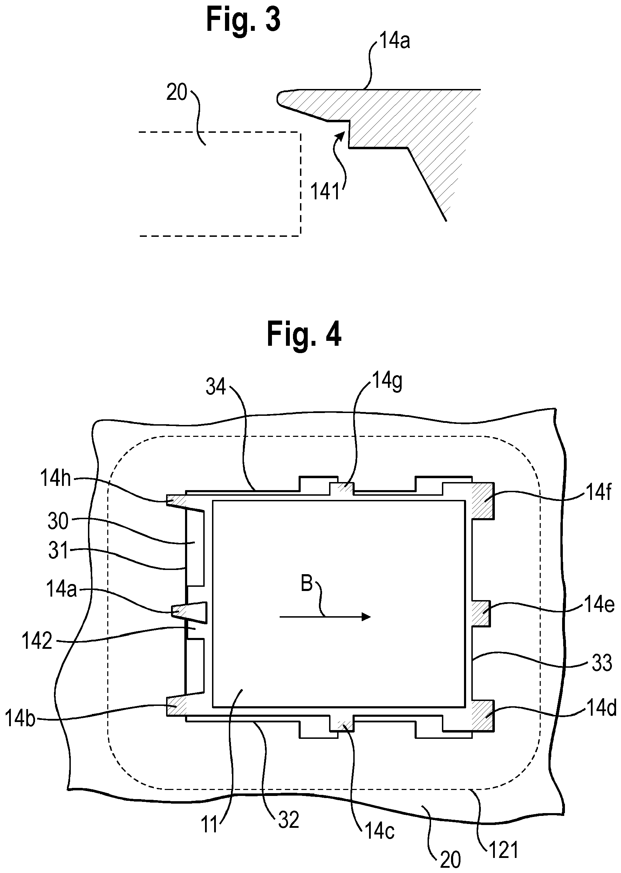

Anhand der Fig. 2 wird nachfolgend die Montage des Hinterlegteils 10 an einer Gehäusewand 20 mit einer darin ausgebildeten passenden Öffnung 30 (siehe auch Fig. 3) erläutert. Im montierten Zustand befindet sich der linksseitige Rand 31 der Öffnung 30 in einem Spalt, der zwischen dem linken Halteelement 14a und der Dichtlippe 12 ausgebildet ist. Der rechtsseitige Rand 33 der Öffnung 30 befindet sich in einem Spalt zwischen dem rechten Halteelement 14e und der Dichtlippe 12. Dies ist durch die Pfeile x und y verdeutlicht. Die Halteelemente 14a und 14e (selbiges gilt für die anderen Halteelemente) dienen hierbei quasi als Gegenlager für die an der Rückseite der Gehäusewand 20 anliegende Dichtlippe 12 und bewirken so das Andrücken der Dichtlippe 12, wobei sich die Dichtlippe 12 elastisch verformt und sich ihrerseits durch elastische Rückstellkräfte an der Rückseite der Gehäusewand 20 abstützt.

Zur Montage wird das Hinterlegteil 10 zunächst von der Rückseite her leicht schräg in die Öffnung 30 eingesetzt, bis das linke Halteelement 14a den linksseitigen Rand 31 der Öffnung 30 vollständig übergreift bzw. umgreift und der linksseitige Rand 31 am Innenbogen zwischen dem Haltelement 14a und der Dichtlippe 12 anschlägt. Diese Einsetzbewegung ist durch den Pfeil A verdeutlicht. Die Relativbewegung zwischen dem Hinterlegteil 10 und der Gehäusewand 20 beträgt hierbei einige Millimeter (z. B. 4 bis 8 mm, bevorzugt etwa 6 mm). Anschließend wird das Hinterlegteil 10 in der Ebene der Gehäusewand 20 in die entgegengesetzte Richtung verschoben, bis das rechte Halteelement 14e den rechtsseitigen Rand 33 der Öffnung 30 übergreift bzw. umgreift und der rechtseitige Rand 33 am Innenbogen zwischen dem Halteelement 14e und der Dichtlippe 12 anschlägt. Diese Verschiebebewegung ist durch den Pfeil B verdeutlicht. Evtl. kann es erforderlich sein, während dieser Verschiebebewegung B das Hinterlegteil 10 entgegen der elastischen Federwirkung der Dichtlippe 12 an die Rückseite der Gehäusewand 20 anzudrücken.

Die Verschiebebewegung B beträgt nur wenige Millimeter (z. B. 2 bis 4 mm, bevorzugt etwa 3 mm, jedenfalls weniger als die Relativbewegung A). Während der Verschiebebewegung B gleitet das länger ausgebildete linke Halteelement 14a gegenüber dem linksseitigen Rand 31 der Öffnung 30 nach rechts zurück, bis das Haltelement 14a in Richtung der Dichtlippe 12 einfedern kann und sich die am Halteelement 14a ausgebildete Rastkante 141 am linksseitigen Rand 31 der Öffnung 30 anlegt. Fig. 3 zeigt eine vergrößerte Darstellung des linken Halteelements 14a mit der integrierten Rastkante 141. Hierdurch wird das Hinterlegteil 10 in einer vorgesehenen Position gegenüber der Öffnung 30 in der Gehäusewand 20 fixiert, was insbesondere auch im Hinblick auf ein nachfolgendes Hinterschäumen sinnvoll ist. Um für die Demontage diese Fixierung zu lösen, muss auf das Anschlussstück 17 und/oder auf die linke Griffeinrichtung 19 manuell eine Druckkraft aufgebracht werden. Das Aufbringen einer solchen Druckkraft kann ggf. auch die Montage des Hinterlegteils 10 erleichtern.

Fig. 4 zeigt in einer Draufsicht die Kontur der Öffnung 30 in der Gehäusewand 20, mit Blick auf die Vorderseite. Mit 31 bis 34 sind die Ränder der Öffnung 30 bezeichnet. Das Hinterlegteil 11 ist hinter die Öffnung eingesetzt und eingerastet. Die schraffierten Flächen kennzeichnen die Bereiche in der Gehäusewand, die nach dem Verschieben des Hinterlegteils 10 in der Richtung B von den Halteelementen 14a bis 14h hintergriffen werden, was aufgrund der Verteilung zu einem annähernd gleichmäßigen Andrücken der Dichtlippe 12 an die Rückseite der Gehäusewand 20 führt. Das Halteelement 14a fungiert gleichzeitig als Fixierelement, daher weist es eine längere Lasche und einen kürzeren flächigen Bereich 142 auf, zwischen denen die Stufe 141 ausgebildet ist. Im dargestellten, eingerasteten Zustand liegt der Außenrand des kürzeren Bereichs 142 am Rand 31 der Öffnung 30 in der Gehäusewand 20 an.

Die Außenumrisslinie der auf der Rückseite anliegenden Dichtlippe 12 ist strichliniert dargestellt und mit 121 bezeichnet. Gut zu erkennen ist der verhältnismäßig große Überlappungsbereich zu den Außenrändern 31 bis 34 der Öffnung 30. Die Kontur der Öffnung 30 ist korrespondierend zum Hinterlegteil 10 ausgebildet. Beispielhaft handelt es sich näherungsweise um eine Rechteckform. Bei Verwendung entsprechender Hinterlegteile kann die Kontur der Öffnung 30 jedoch auch quadratisch, oval, kreisrund oder mit einer sonstigen Form ausgebildet sein.

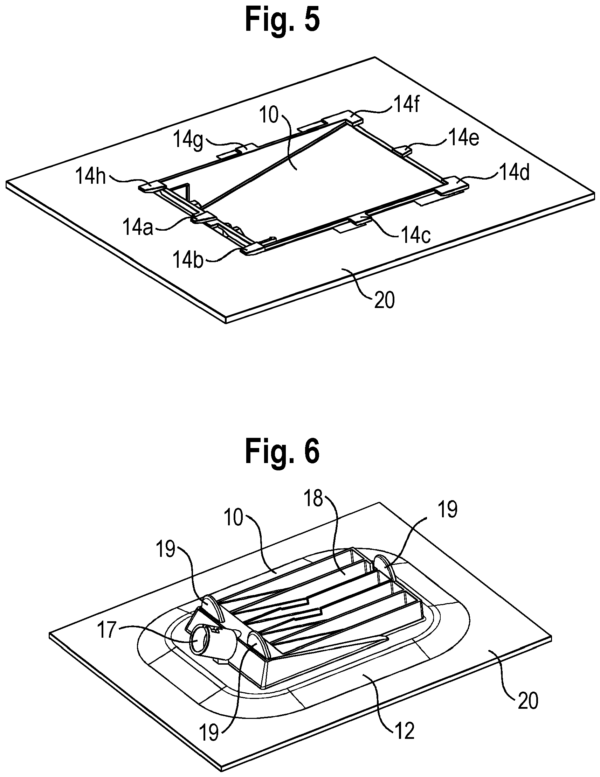

Fig. 5 zeigt das an einer Gehäusewand 20 montierte Hinterlegteil 10 mit Blick auf die Vorderseite. Am Hinterlegteil 10 kann nun von der Vorderseite her ein Oberteil wie insbesondere eine lichtdurchlässige Abdeckung befestigt werden. Die Halteelemente 14a bis 14h sind sowohl in den Eckbereichen als auch in den dazwischenliegenden Seitebereichen angeordnet. Durch das Vorsehen der Halteelemente in den Seitenbereichen kann auch in den entsprechenden Abschnitten der Dichtlippe 12 eine ausreichende Anpresskraft aufgebracht werden. Insbesondere bei groß dimensionierten Hinterlegteilen ist es möglich, in diesen Seitenbereichen auch mehrere Halteelemente vorzusehen.

Fig. 6 zeigt das an der Gehäusewand 20 montierte Hinterlegteil 10 mit Blick auf die Rückseite. Wie aus der gezeigten Darstellung ersichtlich, legt sich die komplette Dichtlippe 12 umlaufend um die nicht sichtbare Öffnung 30 flach an die Rückseite der Gehäusewand 20 an und erstreckt sich dabei im wesentlichen parallel zur Gehäusewand 20.

## Patentansprüche

1. Hinterlegteil (10) für die Befestigung einer elektrischen Komponente an der Gehäusewand (20) eines Haushaltselektrogeräts, insbesondere für die Befestigung einer elektrischen Komponente an der Innenwand eines Haushaltskältegeräts, mit einem Korpus (11) und einem umlaufenden Randsteg, wobei das Hinterlegteil (10) dazu ausgelegt ist, hinter einer passenden Öffnung (30) in der Gehäusewand (20) angeordnet zu werden und sich mit dem Randsteg an der Rückseite der Gehäusewand abzustützen, wobei der umlaufende Randsteg als elastische Dichtlippe (12) ausgebildet ist, und dass das Hinterlegteil (10) mit einer Vielzahl von Halteelementen (14a-14h) ausgebildet ist, die vom Korpus (11) abstehen und zwischen sich und der Dichtlippe (12) einen Spalt (x, y) bilden, der dazu ausgelegt ist, einen Abschnitt der Gehäusewand (20) am Rand (31-34) der Öffnung (30) aufzunehmen, wobei diese Halteelemente (14a-14h) derart über den Umfang des Hinterlegteils (10) verteilt angeordnet sind, dass in jeden Abschnitt der Dichtlippe (12) eine ausreichende Anpresskraft eingeleitet wird, wenn das Hinterlegeteil (10) hinter einer passenden Öffnung (30) in der Gehäusewand (20) befestigt ist, **dadurch gekennzeichnet, dass** es eine zumindest im Wesentlichen rechteckige Grundfläche aufweist, wobei an jeder der vier Seiten des Rechtecks zumindest ein Halteelement (14a-14h) angeordnet ist, wobei zusätzlich jeweils ein Halteelement (14a-14h) an den Ecken des Hinterlegteils (10) vorgesehen ist.

2. Hinterlegteil (10) nach Anspruch 1,
**dadurch gekennzeichnet, dass**
die Halteelemente (14a-14h) flächig ausgebildet sind und sich in etwa parallel zur Dichtlippe (12) erstrecken.

3. Hinterlegteil (10) nach einem der vorhergehenden Ansprüche,
**dadurch gekennzeichnet, dass**
wenigstens ein Halteelement (14a) gleichfalls als Fixierelement ausgebildet ist, welches das Hinterlegteil (10) in einer vorgesehenen Position gegenüber der Öffnung (30) in der Gehäusewand (20) fixiert.

4. Hinterlegteil (10) nach Anspruch 3, **dadurch gekennzeichnet, dass**
das Fixierelement (14a) eine Stufe (141) auf seiner der Dichtlippe (12) zugewandten Seite aufweist, welche eine Rastposition für den Rand (31) der Öffnung (30) darstellt.

5. Hinterlegteil (10) nach einem der vorausgehenden Ansprüche,
**dadurch gekennzeichnet, dass**
die Dichtlippe (12) flächig und mit einer leichten Neigung ausgebildet ist.

6. Hinterlegteil (10) nach einem der vorausgehenden Ansprüche,
**dadurch gekennzeichnet, dass**
der Korpus (11) mit einem integrierten Reflektorabschnitt (16) ausgebildet ist.

7. Beleuchtungseinrichtung für ein Haushaltselektrogerät, insbesondere Innenbeleuchtungseinrichtung für ein Kältegerät, umfassend ein Hinterlegteil (10) gemäß einem der vorausgehenden Ansprüche und ein damit verbindbares Oberteil.

8. Haushaltselektrogerät, insbesondere Haushaltskältegerät, mit wenigstens einem Hinterlegteil (10) gemäß einem der Ansprüche 1-6 und/oder mit wenigstens einer Beleuchtungseinrichtung gemäß Anspruch 7.

9. Verfahren zur Montage eines Hinterlegteils (10) gemäß einem der Ansprüche 1 bis 6 an der Gehäusewand (20) eines Haushaltselektrogeräts, wobei das Hinterlegteil (10) von der Rückseite her in eine passende Öffnung (30) in der Gehäusewand (20) eingesetzt (A) und nachfolgend in einer entgegengesetzten Bewegungsrichtung (B) in der Ebene der Gehäusewand (20) verschoben wird, bis alle Halteelemente (14a-14h) des Hinterlegteils (10) den Rand (31-34) der Öffnung (30) in der Gehäusewand (20) umgreifen und/oder hintergreifen.

## Claims

1. Backing piece (10) for attaching an electrical component to the housing wall (20) of an electrical household appliance, in particular for attaching an electrical component to the inner wall of an electrical household appliance, having a body (11) and a peripheral web, the backing piece (10) being designed to be arranged behind a matching opening (30) in the housing wall (20) and to be supported with the peripheral web against the rear face of the housing wall,
wherein
the peripheral web is configured as an elastic sealing lip (12) and the backing piece (10) is configured with a plurality of holding elements (14a-14h), which project from the body (11) and form a gap (x, y) between themselves and the sealing lip (12), said gap (x, y) being designed to receive a section of the housing wall (20) at the edge (31-34) of the opening (30), said holding elements (14a-14h) being distributed over the periphery of the backing piece (10) in such a manner that a sufficient pressing force is introduced into each section of the sealing lip (12), when the backing piece (10) is attached behind a matching opening (30) in the housing wall (20), **characterised in that** it has an at least essentially rectangular base surface, with at least one holding element (14a-14h) arranged on each of the four sides of the rectangle, with one holding element (14a-14h) also being provided at each of the corners of the backing piece (10).

2. Backing piece (10) according to claim 1,
**characterised in that**
the holding elements (14a-14h) are configured as planar and extend roughly parallel to the sealing lip (12).

3. Backing piece (10) according to one of the preceding claims,
**characterised in that**
at least one holding element (14a) is also configured as a fixing element, which fixes the backing piece (10) in an intended position in relation to the opening (30) in the housing wall (20).

4. Backing piece (10) according to claim 3,
**characterised in that**
the fixing element (14a) has a step (141) on its side facing the sealing lip (12), providing a latching position for the edge (31) of the opening (30).

5. Backing piece (10) according to one of the preceding claims,
**characterised in that**
the sealing lip (12) is configured as planar and with a slight inclination.

6. Backing piece (10) according to one of the preceding claims,
**characterised in that**
the body (11) is configured with an integrated reflector section (16).

7. Lighting facility for an electrical household appliance, in particular internal lighting facility for a refrigeration appliance, comprising a backing piece (10) according to one of the preceding claims and an upper part that can be connected thereto.

8. Electrical household appliance, in particular household refrigeration appliance, having at least one backing piece (10) according to one of claims 1-6 and/or having at least one lighting facility according to claim 7.

9. Method for mounting a backing piece (10) according to one of claims 1 to 6 on the housing wall (20) of an electrical household appliance, wherein the backing piece (10) is inserted (A) from the rear into a matching opening (30) in the housing wall (20) and then displaced in a counter movement direction (B) in the plane of the housing wall (20), until all the holding elements (14a-14h) of the backing piece (10) engage around and/or behind the edge (31-34) of the opening (30) in the housing wall (20).

## Revendications

1. Pièce de support (10) pour la fixation d'un élément électrique sur la paroi de boîtier (20) d'un appareil électroménager, notamment pour la fixation d'un élément électrique sur la paroi interne d'un appareil électroménager, comprenant un corps (11) et une nervure de bord périphérique, la pièce de support (10) étant conçue pour être disposée derrière une ouverture correspondante (30) dans la paroi de boîtier (20) et pour s'appuyer avec la nervure de bord contre la face arrière de la paroi de boîtier,
dans laquelle la nervure de bord périphérique est conçue sous forme d'une lèvre d'étanchéité (12) élastique et la pièce de support (10) est formée d'une pluralité d'éléments de retenue (14a-14h), qui sont en saillie par rapport au corps (11) et forment entre eux et la lèvre d'étanchéité (12) un interstice (x, y) conçu pour recevoir une partie de la paroi de boîtier (20) au bord (31-34) de l'ouverture (30), et ces éléments de retenue (14a-14h) sont répartis sur la périphérie de la pièce de support (10) de manière à créer une force de pression suffisante dans chaque partie de la lèvre d'étanchéité (12) lorsque la pièce de support (10) est fixée derrière une ouverture correspondante (30) dans la paroi de boîtier (20),
**caractérisée en ce qu'**elle possède une surface de base au moins sensiblement rectangulaire, et dans laquelle au moins un élément de retenue (14a-14h) est disposé sur chacun des quatre côtés du rectangle, un élément de retenue (14a-14h) étant agencé en plus respectivement aux quatre coins de la pièce de support (10).

2. Pièce de support (10) selon la revendication 1, **caractérisée en ce que** les éléments de retenue (14a-14h) sont formés de façon plane et s'étendent sensiblement parallèlement à la lèvre d'étanchéité (12).

3. Pièce de support (10) selon l'une des revendications précédentes, **caractérisée en ce qu'**au moins un élément de retenue (14a) est formé également d'un élément de fixation qui fixe la pièce de support (10) dans une position prévue par rapport à l'ouverture (30) dans la paroi de boîtier (20).

4. Pièce de support (10) selon la revendication 3, **caractérisée en ce que** l'élément de fixation (14a) possède un palier (141) sur son côté faisant face à la lèvre d'étanchéité (12) qui constitue une position d'encliquetage pour le bord (31) de l'ouverture (30).

5. Pièce de support (10) selon l'une des revendications précédentes, **caractérisée en ce que** la lèvre d'étanchéité (12) est formée de façon plane et présente une légère inclinaison.

6. Pièce de support (10) selon l'une des revendications précédentes, **caractérisée en ce que** le corps (11) est formé avec une partie de réflecteur (16) intégrée.

7. Dispositif d'éclairage pour un appareil électroménager, en particulier dispositif d'éclairage intérieur pour un appareil frigorifique, comprenant une pièce de support (10) selon l'une des revendications précédentes et une pièce supérieure pouvant y être assemblée.

8. Appareil électroménager, notamment appareil frigorifique ménager, comprenant au moins une pièce de support (10) selon l'une des revendications 1 à 6 et/ou au moins un dispositif d'éclairage selon la revendication 7.

9. Procédé de montage d'une pièce de support (10) selon l'une des revendications 1 à 6 sur la paroi de boîtier (20) d'un appareil électroménager, selon lequel la pièce de support (10) est insérée (A) du côté de la face arrière dans une ouverture correspondante (30) dans la paroi de boîtier (20) et est déplacée ensuite dans une direction de déplacement opposée (B) dans le plan de la paroi de boîtier (20), jusqu'à ce que tous les éléments de retenue (14a-14h) de la pièce de support (10) enveloppent et/ou saisissent par derrière le bord (31-34) de l'ouverture (30) dans la paroi de boîtier (20).
